# EUROPEAN PATENT SPECIFICATION

(11) **EP 1 865 757 B1**
(45) Date of publication and mention of the grant of the patent: **02.03.2011**
(21) Application number: 06290932.0
(22) Date of filing: 06.06.2006
(51) Int. Cl.: H05K 1/02

(54) **Reduced crosstalk in printed circuit boards by twisting tracks**
Verringertes Übersprechen in gedruckten Leiterplatten mittels Verdrillung von Leiterbahnen
Diaphonie réduite dans des cartes de circuit imprimé par pistes torsadées

(43) Date of publication of application: 12.12.2007
(73) Proprietor: Alcatel Lucent, 75008 Paris (FR)
(72) Inventor: Fossion, Marc Jean Joseph, 5140 Ligny (BE); Fossion, Stéphanie Cécile Marie, 1030 Brussels (BE)
(74) Representative: Narmon, Gisèle Marie Thérèse

(56) References cited:
- EP-A2- 0 855 854
- WO-A-95/06955
- US-A- 3 757 028
- US-A- 3 761 842
- US-B1- 6 396 000

## Description

The present invention relates to a Printed Circuit Board PCB provided with a plurality of pairs of parallel wires following a same path from a start area to an end area on said PCB, the wires of at least one of said pairs being constituted by a plurality of consecutive sections running from said start area to said end area.

A Printed Circuit Board, generally referred to as PCB, whereon differential signals are routed on distinct pairs of adjacent copper wires, with each pair following a predetermined path on the PCB, is generally known in the art.

On the known design, a problem may occur if several differential signals are adjacently routed on the PCB. The adjacent pairs of wires, also called lines, then present mutual inductance and capacitance, which result in electromagnetic interference between these lines. As a consequence, the signal integrity may be negatively affected by a coupled signal acting as noise and causing a degradation of the data transmission performances. This coupling effect between adjacent lines is called "cross-talk".

In particular applications such as VDSL2, using much higher frequencies than ADSL and ADSL2+ (30MHz vs 2.2MHz), the crosstalk in a PCB becomes very critical.

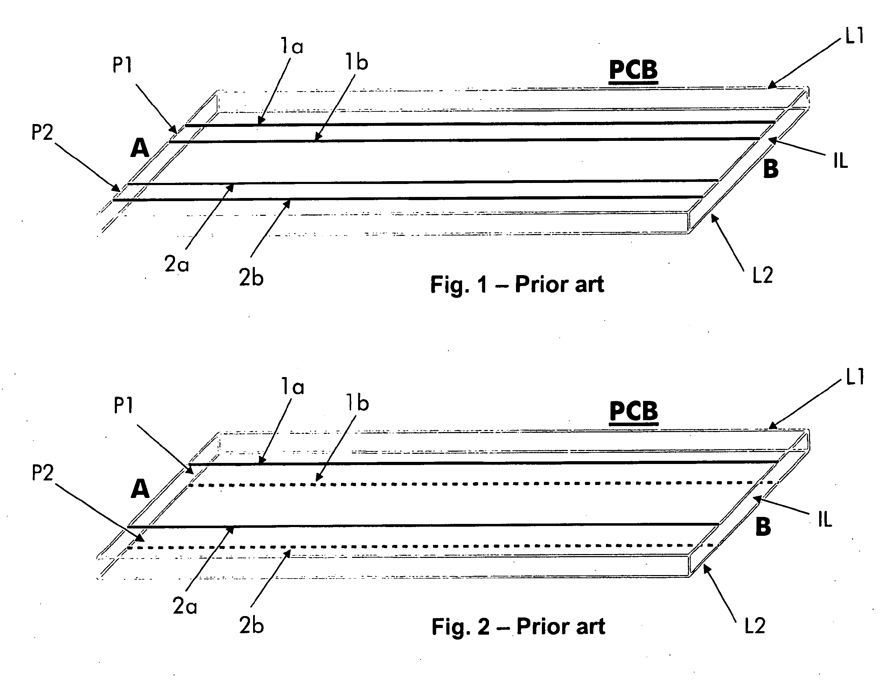

The currently used PCB layout techniques to minimize the cross-talk are the following:
- in case of same layer cross-talk, i.e. cross-talk between signals routed on the same layer L1 as shown at Fig. 1, the cross-talk can be reduced by limiting the parallel run length of lines, by keeping the two wires 1a, 1b of a differential signal as closest as possible and by maximizing the distance separating cross-talking pairs of wires, i.e. between 1a, 1b and 2a, 2b;
- in case of adjacent layers cross-talk, i.e. cross-talk between signals routed on adjacent layers L1 and L2 as shown at Fig. 2, the cross-talk can be controlled by separating the two layers with ground planes IL or by applying an orthogonal routing.

Twisting at least a part of the adjacent lines or routing pairs of wires on the PCB significantly reduces the electromagnetic coupling between adjacent differential signals.

To be really efficient, these known cross-talk reduction techniques require a lot of PCB area or additional layers, so most of the time they cannot be optimally applied due to the limited number of layers and the high PCB density.

The International Patent Application WO 95/06955 A of MOTOROLA INC [US] (9 March 1995) entitled "A TWISTED-PAIR PLANAR CONDUCTOR LINE OFF-SET STRUCTURE" discloses a twisted-pair conductor line structure wherein two conductors are separated by pockets of insulating material. The two conductors are substantially planar because the top conductor could be disposed on the same plane as the bottom conductor, during the parallel sections and then disposed over the insulating pockets, during the crossed sections.

An object of the present invention is to provide a Printed Circuit Board PCB of the above known type but whereon the magnetic and electric coupling between lines is reduced while not requiring additional PCB area or additional layers.

According to the present invention, this object is achieved due to the fact that the two wires of said one pair are located on a same first layer of said PCB, and that, alternately, at the junction between each consecutive sections, a first one of said two wires crosses the second one of said two wires by a bypass on a second layer of the PCB.

The bypass, also called via, allows the first wire, located of a first layer of the PCB, to cross the second wire also located on this first layer, by passing shortly on the second layer and returning on the first layer at each section intersection. This technique doesn't require additional area on the PCB, especially on the second side thereof, contrary to currently known designs described above.

It is to be noted that other documents also disclose designs for reducing the magnetic and electric coupling between lines. However, they don't disclose nor teach a structure having the advantages of the present invention.

For instance, the US Patent US-B1-6 396 000 of BAUM AARON M [US] (28 May 2002) and entitled "Printed circuit board and method for reducing radio frequency interference emissions from conductive traces on a printed circuit board" discloses a printed circuit board including a first helical conductive trace and a second helical conductive trace. The first helical conductive trace extends generally along a longitudinal axis of a layer of the printed circuit board. The first helical conductive trace is provided successively: along a first surface, from the first surface through the layer to a second surface, along the second surface, and from the second surface through the layer to the first surface. The second helical conductive trace extends generally along the longitudinal axis of the layer of the printed circuit board. The second helical conductive trace is provided successively: along the second surface, from the second surface through the layer to the first surface, along the first surface, and from the first surface through the layer to the second surface.

The European Patent Application EP-A2-0 855 854 of MOLEX INC [US] (29 July 1998) entitled "Flexible printed circuitry with pseudo-twisted conductors" discloses a flexible printed circuitry member including a generally planar dielectric substrate. First and second pseudo-twisted conductors are disposed on opposite sides of the substrate and extend longitudinally in a pattern of twist sections between crossover points whereat the conductors cross over each other separated by the dielectric substrate. The crossover points define a centerline with the first and second conductors reversing each other on opposite sides of the centerline at each crossover point. The twist sections between crossover points along the centerline are of randomly differing lengths.

The US Patent Application US-A-3 761 842 of BENTLEY GANDRUD W. (25 September 1973) entitled "TWISTED PAIR FLAT CONDUCTOR CABLE WITH MEANS TO EQUALIZE IMPEDANCE AND PROPAGATION VELOCITY" discloses the use of so-called paired flat cable in interconnection work which is attractive because of mass termination and rearrangement cost benefits. Flat cable has been supplied with differing twist lengths to meet crosstalk problems.

The US Patent Application US-A-3 757 028 of SCHLESSEL J. (4 September 1973) entitled "PRINTED BOARD AND SIMILAR TRANSMISSION LINE STRUCTURE FOR REDUCING IN TERFERENCE" discloses a novel transmission-line structure, particularly adapted for printed circuit sheets and the like, and embodying zig-zag line conductors formed of conductive strips successively disposed on opposite sides of the insulating sheet and interconnected transversely through the sheet, with the corresponding strips of each line conductor crossing those of the other line conductor, through on opposite sides of said sheet, effectively to provide a twist of the line conductors through at least a turn to effect magnetic field cancellation, self-shielding and interference suppression.

Another characterizing embodiment of the present invention is that said second layer of the PCB is separated from said first layer by an insulating layer.

Further characterizing embodiments of the present Printed Circuit Board PCB are mentioned in the appended claims.

It is to be noticed that the term 'comprising', used in the claims, should not be interpreted as being restricted to the means listed thereafter. Thus, the scope of the expression 'a device comprising means A and B' should not be limited to devices consisting only of components A and B. It means that with respect to the present invention, the only relevant components of the device are A and B.

The above and other objects and features of the invention will become more apparent and the invention itself will be best understood by referring to the following description of an embodiment taken in conjunction with the accompanying drawings showing two cross-talking differential pairs of lines and the possible ways to route them, wherein:
Fig. 1 represents a Printed Circuit Board PCB as known from the prior art with pairs of wires running on a single layer of the PCB;
Fig. 2 represents a PCB as also known from the prior art with each wire of a pair running on a distinct layer of the PCB; and
Fig. 3 represents a PCB according to the invention with the wires of a pair running on a single layer of the PCB and crossing each other several times.

In the traditional design of Printed Circuit Boards PCB, a differential signal is routed as a differential pair P1; P2 of two adjacent copper wires, also called lines, 1a, 1b; 2a, 2b currently routed as two parallel wires following a same path from a start area A to an end area B on the PCB, as shown on the prior art design Figs. 1 and 2.

Problems can occur if several differential signals have to be adjacently routed on the PCB: these adjacent pairs P1; P2 of lines present mutual inductance and capacitance which result in electromagnetic interference between the lines. The signal integrity is affected by a coupled signal acting as noise and causing a degradation of the data transmission performances. This coupling effect between adjacent lines is called "cross-talk" and may become very critical in particular applications such as VDSL2 that is using much higher frequencies (30MHz) than ADSL or ADSL2+ (2.2MHz).

The known PCB layout techniques to minimize the cross-talk are:
- in case of cross-talk between signals routed on two differential pairs of wires located on a same layer L1 of the PCB, as shown at Fig. 1: to limit the parallel run length of the lines by keeping the two wires 1a, 1b of a same differential signal as close as possible and to maximize the distance separating cross-talking pairs of wires, i.e. between the pairs of wires 1a, 1b and 2a, 2b;
- in case of cross-talk between signals routed on two differential pairs of which the wires are located on adjacent layers L1 and L2 of the PCB, as shown at Fig. 2: to separate the two layers with a ground plane or an insulating layer IL or to apply an orthogonal routing.

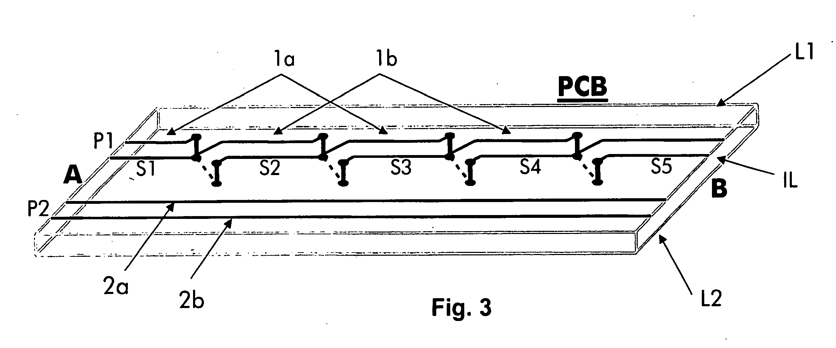

However, these known PCB designs have drawbacks as explained above and are advantageously replaced by the PCB technique of the present invention as will be described below by making reference to Fig. 3.

The principle of the invention consists in regularly twisting the two parallel wires 1a, 1b of a same differential pair P1 along their way from the start point A to the end point B; at least for one of the two differential pairs.

The implementation of this invention is shown at Fig. 3. Therein, the two wires 1a, 1b constituting the differential pair P1 are on a same layer L1 of the PCB. The wires 1a, 1b of the pair P1 are constituted by a plurality of consecutive sections S1, S2, S2, S4 and S5. Each section comprises the two wires and is running on the layer L1 from the start area A to the end area B. Between each consecutive section, the two wires 1a and 1b are twisted. To this end, the first wire 1a crosses the second wire 1b by means of a bypass V1 to V4, also called via, through the second layer L2 of the PCB. The first layer L1 and the second layer L2 of the PCB are separated by an insulating layer IL.

It is to be noted that each section S 1 - S5 has a length of about 25 mm.

While the principles of the invention have been described above in connection with specific apparatus, it is to be clearly understood that this description is merely made by way of example and not as a limitation on the scope of the invention, as defined in the appended claims.

## Claims

1. A Printed Circuit Board PCB provided with a plurality of pairs (P1; P2) of parallel wires (1a, 1b; 2a, 2b) following a same path from a start area (A) to an end area (B) on said PCB,
the wires (1a, 1b) of at least one (P1) of said pairs (P1; P2) being constituted by a plurality of consecutive sections (S1 - S5) running from said start area (A) to said end area (B),
**characterized in that** the two wires (1a, 1b) of said one pair (P1) are located on a same first layer (L1) of the PCB,
and **in that**, alternately, at the junction between each consecutive sections (S1 - S5), a first one (1a) of said two wires crosses the second one (1b) of said two wires by a bypass (V1 - V4) on a second layer (L2) of the PCB.

2. The PCB according to claim 1, **characterized in that** said second layer (L2) of the PCB is separated from said first layer (L1) by an insulating layer (IL).

3. The PCB according to claim 1, **characterized in that** said pairs (P1; P2) of parallel wires are adapted to carry a differential signal.

4. The PCB according to claim 1, **characterized in that** each of said sections (S1 - S5) has a length of about 25 mm.

## Patentansprüche

1. Gedruckte Leiterplatte PCB mit einer Mehrzahl von Paaren (P1; P2) von parallelen Drähten (1a, 1 b; 2a, 2b), welche auf einem selben Pfad von einem Startbereich (A) zu einem Endbereich (B) auf der besagten PCB verlaufen,
wobei die Drähte (1a, 1b) mindestens eines (P1) der besagten Paare (P1; P2) aus einer Mehrzahl von aufeinanderfolgenden Abschnitten (S1 - S5) bestehen, welche von dem besagten Startbereich (A) bis zu dem besagten Endbereich (B) verlaufen,
**dadurch gekennzeichnet, dass** die beiden Drähte (1a, 1 b) des besagten einen Paars (P1) auf einer selben ersten Schicht (L1) der PCB angeordnet sind,
und dass, wechselweise, am Übergang zwischen einem jeden der aufeinanderfolgenden Abschnitte (S1 - S5), ein erster (1a) der besagten zwei Drähte den zweiten (1b) der besagten zwei Drähte über einen Bypass (V1 - V4) auf einer zweiten Schicht (L2) der PCB überquert.

2. Die PCB nach Anspruch 1, **dadurch gekennzeichnet, dass** die besagte zweite Schicht (L2) der PCB durch eine Isolierschicht (IL) von der besagten ersten Schicht (L1) getrennt ist.

3. Die PCB nach Anspruch 1, **dadurch gekennzeichnet, dass** die besagten Paare (P1; P2) von parallelen Drähten fähig sind, ein Differenzsignal zu transportieren.

4. Die PCB nach Anspruch 1, **dadurch gekennzeichnet, dass** ein jeder der besagten Abschnitte (S1 - S5) eine Länge von etwa 25 mm aufweist.

## Revendications

1. Circuit imprimé PCB muni d'une pluralité de paires (P1 ; P2) de fils parallèles (1a, 1 b ; 2a, 2b) suivant le même trajet d'une zone de départ (A) vers une zone finale (B) sur ledit PCB,
les fils (1a, 1 b) d'au moins l'une (P1) desdites paires (P1 ; P2) étant constitués d'une pluralité de sections consécutives (S1 - S5) s'étendant de ladite zone de départ (A) vers ladite zone finale (B),
**caractérisé en ce que** les deux fils (1a, 1b) de ladite une paire (P1) se trouvent sur une même première couche (L1) du PCB,
et **en ce qu'**en variante, au niveau de la jonction entre chacune des sections consécutives (S1 - S5), un premier (1a) desdits deux fils croise le deuxième (1b) desdits deux fils par un contournement (V1 - V4) sur une deuxième couche (L2) du PCB.

2. PCB selon la revendication 1, **caractérisé en ce que** ladite deuxième couche (L2) du PCB est séparée de ladite première couche (L1) par une couche isolante (IL).

3. PCB selon la revendication 1, **caractérisé en ce que** lesdites paires (P1 ; P2) de fils parallèles sont adaptées pour transporter un signal différentiel.

4. PCB selon la revendication 1, **caractérisé en ce que** chacune desdites sections (S1 - S5) a une longueur d'environ 25 mm.
